# EUROPEAN PATENT SPECIFICATION

(11) **EP 2 673 806 B1**
(45) Date of publication and mention of the grant of the patent: **05.05.2021**
(21) Application number: 11857416.9
(22) Date of filing: 12.02.2011
(51) Int. Cl.: H01L 21/336, H01L 29/78, H01L 29/08, H01L 29/423

(54) **Fabrication method of a semiconductor device**
Verfahren zum Herstellen eines Halbleiterbauelements
Procédé de fabrication d'un dispositif semi-conducteur

(43) Date of publication of application: 18.12.2013
(73) Proprietor: NXP USA, Inc., Austin TX 78735 (US)
(72) Inventor: WANG, Peilin, Beijing 100022 (CN); CHEN, Jingjing, Beijing 100022 (CN); EDOUARD, D, Defresart, Tempe, AZ 85284 (US)
(74) Representative: Hardingham, Christopher Mark
(86) International application number: PCT/CN2011/000219
(87) International publication number: WO 2012/106833

(56) References cited:
- WO-A2-2010/065428
- JP-A- S6 237 965
- JP-A- 55 130 173
- JP-A- 62 037 965
- JP-A- H02 156 679
- JP-A- S55 130 173
- JP-A- 2007 281 149
- US-A1- 2010 078 707
- US-B1- 6 303 410

## Description

### TECHNICAL FIELD

Embodiments of the subject matter described herein relate generally to methods for fabricating semiconductor devices, and more particularly, embodiments of the subject matter relate to methods for fabricating trench field effect transistor structures that include lateral gate structures.

### BACKGROUND

Decreasing transistor size has traditionally been a high priority in the semiconductor manufacturing industry. Trench metal oxide semiconductor field-effect transistors (MOSFETs) are commonly used to provide desired transistor functionality with reduced die size relative to lateral MOSFET devices. Traditionally, the required size of a trench MOSFET was dictated by the desired on-state resistance. More recently, the required size of a trench MOSFET is dictated by the desired energy (or current) capability and/or the desired thermal stability.

United States patent publication number US6,303,410 B1 discloses methods of forming power semiconductor devices having T-shaped gate electrodes. The methods include forming a semiconductor substrate having a drift region of first conductivity type therein extending to the face thereof and forming a trench in the substrate so that the trench has a sidewall which extends from drift region to the face. A conductive layer on the gate electrode is patterned to define a T-shaped or Y-shaped gate electrode which fill the trench and also extends off the face at a location adjacent the trench.

Japanese patent publication number JP S55 130173 A discloses an insulated gate field-effect transistor (IGFET), in which boron is selectively diffused in an epitaxial layer to form a P-type first impurity region. Phosphorus is diffused to form an N-type second impurity region 14. An anisotropic etching is conducted to form a V shaped groove through the regions.

Japanese patent publication number JP H02 156679 A discloses another example of a field effect transistor having a trench structure provided by the V-grooves. JP S62 37965 A discloses a semiconductor device with separated trench gate structure and lateral gate structure, with a p-type body region formed by implanting and diffusing ions and with an-type source region formed by implanting ions, being adjacent to both the trench gate and the lateral gate structures.

### BRIEF DESCRIPTION OF THE DRAWINGS

A more complete understanding of the subject matter may be derived by referring to the detailed description and claims when considered in conjunction with the following figures, wherein like reference numbers refer to similar elements throughout the figures.
FIGS. 1-12 illustrate cross-sectional and top views of a semiconductor device structure and exemplary methods for fabricating the semiconductor device structure in accordance with one or more embodiments of the invention;
FIG. 13 illustrates a cross-sectional view of a semiconductor device structure useful for understanding of the invention; and
FIG. 14 illustrates a cross-sectional view of a semiconductor device structure in accordance with another embodiment not being part of the invention.

### DETAILED DESCRIPTION

The following detailed description is merely illustrative in nature and is not intended to limit the embodiments of the subject matter or the application and uses of such embodiments. As used herein, the word "exemplary" means "serving as an example, instance, or illustration." Any implementation described herein as exemplary is not necessarily to be construed as preferred or advantageous over other implementations. Furthermore, there is no intention to be bound by any expressed or implied theory presented in the preceding technical field, background, brief summary or the following detailed description.

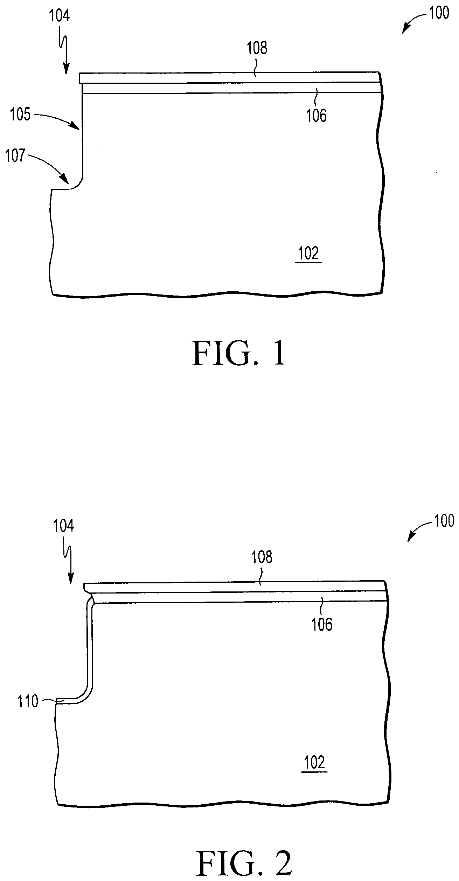

FIGS. 1-12 illustrate methods for fabricating a semiconductor device structure 100. As described in greater detail below, the semiconductor device structure 100 is realized as a trench metal oxide semiconductor field-effect transistor (MOSFET) that includes a lateral gate structure to increase the effective channel length and reduce heat density, thereby improving the energy handling capability of the trench MOSFET for a given die size. Although "MOS" properly refers to a device having a metal gate electrode and an oxide gate insulator, the subject matter may be utilized with any semiconductor device that includes a conductive gate electrode (whether metal or other conductive material) that is positioned with respect to a gate insulator (whether oxide or other insulator) which, in turn, is positioned with respect to a semiconductor substrate to implement a field-effect transistor, and the subject matter is not intended to be limited to a metal gate electrode and an oxide gate insulator. Furthermore, it should be appreciated that although the subject matter may be described herein in the context of an N-type (or N-channel) device, the subject matter is not intended to be limited to N-type devices and may be implemented in an equivalent manner for a P-type (or P-channel) device. Various steps in the manufacture of MOS devices are well known and so, in the interest of brevity, many conventional steps will only be mentioned briefly herein or will be omitted entirely without providing the well known process details.

Referring to FIG. 1, the illustrated fabrication process begins by providing an appropriate substrate of semiconductor material 102 and forming a voided region 104 (alternatively referred to herein as a trench) in the semiconductor material 102. In an exemplary embodiment, the semiconductor material 102 is realized as a silicon material as is typically used in the semiconductor industry (e.g., relatively pure silicon or silicon admixed with other elements such as germanium, carbon, and the like), although it will be appreciated that other semiconductor materials may be used in alternative embodiments. Accordingly, for convenience, but without limitation, the semiconductor material 102 is alternatively referred to herein as a silicon material. In an exemplary embodiment, the silicon material 102 is doped with ions of a conductivity-determining impurity type to provide an electrode region or terminal region (e.g., a drain region) for the device structure 100. For example, for an N-channel device, the silicon material 102 may be doped with N-type ions, such as phosphorous ions (or a phosphorous ionized species), having a dopant concentration of about 1.0 × 10¹⁶/cm³ . In accordance with one embodiment, the doped silicon material 102 is formed by epitaxially growing the silicon material 102 on a semiconductor substrate (e.g., a bulk silicon substrate, a silicon on insulator substrate, or the like) and in-situ doping the silicon material 102 by adding phosphorous ions to the reactants used to epitaxially grow the silicon material 102.

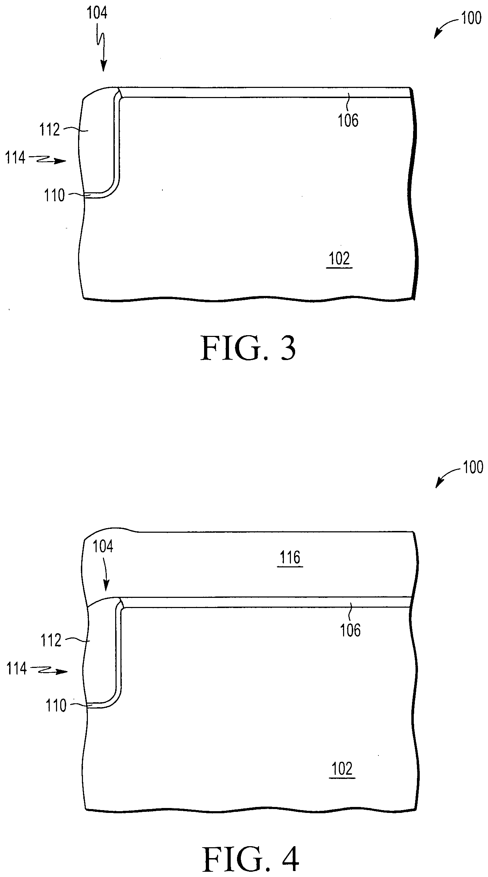

In an exemplary embodiment, the trench 104 is formed by forming a layer of masking material overlying the silicon material 102, patterning the masking material to expose a portion of the silicon material 102 to be removed, and selectively removing the exposed portion of the silicon material 102 using the remaining masking material as an etch mask. In the illustrated embodiment, a layer of dielectric material 106, such as an oxide material, is formed overlying the silicon material 102, and a layer of masking material 108 is formed overlying the dielectric material 106. The layer of masking material 108 may be formed by conformably depositing a hard mask material, such as a nitride material (e.g., silicon nitride, silicon oxynitride, or the like), overlying the layer of dielectric material 106 to accommodate the selective etching of underlying silicon material 102 when subsequently used as an etch mask. For convenience, but without limitation, the masking material 108 may hereinafter be referred to as the pad nitride. In an exemplary embodiment, the pad nitride 108 is patterned to expose the portion of the silicon material 102 to be removed for the trench 104 while masking the remaining silicon material 102, and an anisotropic etchant is utilized to remove exposed (or unmasked) portions of the dielectric material 106 and the silicon material 102 to form the trench 104. For example, the unmasked portion of silicon material 102 may be anisotropically etched by plasma-based reactive ion etching (RIE) using an anisotropic etchant chemistry, such as a fluorocarbon-based plasma chemistry that etches the silicon material 102 with good selectivity relative to the pad nitride 108. In accordance with one or more embodiments, the trench 104 is etched to a depth in the range of about one to two micrometers (or microns) relative to the surface of the silicon material 102. The trench 104 in the silicon material 102 defines the dimensions and/or shape of a trench gate structure subsequently formed therein, as described in greater detail below in the context of FIG. 3.

In accordance with one or more embodiments, after forming the trench 104, the fabrication process continues by forming a sacrificial oxide layer in the trench 104 and removing the sacrificial oxide layer to reduce the roughness of the bottom and sidewall surfaces of the trench 104 and round the corners of the trench 104 to prevent creation of uneven electric fields at the corners of the trench 104. For example, a sacrificial oxide layer may be thermally grown on the bottom surface 107 and the sidewall surface 105 of the trench 104 by exposing the device structure 100 of FIG. 1 to an oxidizing ambient at an elevated temperature that promotes selective growth of oxide material on the exposed surfaces 105, 107 of the silicon material 102. In an exemplary embodiment, the sacrificial oxide layer is formed to a thickness in the range of about 30 nanometers (nm) to about 100 nm. In practice, during the oxidation process, oxide material may also grow on the exposed dielectric material 106 and/or pad nitride 108; however, the oxidation rate of the silicon material 102 is sufficiently greater than the oxidation rate of the dielectric material 106 and/or pad nitride 108 such that the amount of oxide material formed on the dielectric material 106 and/or pad nitride 108 is negligible. The sacrificial oxide layer is then completely removed from the bottom and sidewall surfaces 105, 107 of the trench 104 using an isotropic etchant chemistry that etches oxide material with good selectivity relative to the pad nitride 108, such that the dielectric material 106 and pad nitride 108 remain substantially intact after the sacrificial oxide layer is removed (although the dielectric material 106 and/or pad nitride 108 may be partially etched). As illustrated in FIG. 1, the formation and subsequent etching of the sacrificial oxide layer rounds the corners and edges of the trench 104, including where the bottom surface 107 and sidewall surface 105 intersect and where the sidewall surface 105 and the upper surface of the silicon material 102 intersect, to improve uniformity of a gate dielectric material for a trench gate structure subsequently formed in the trench 104 and reduce peak electric fields at the corners of the trench 104.

Referring now to FIG. 2, in an exemplary embodiment, the fabrication process continues by forming a layer of dielectric material 110 in the trench 104. The dielectric material 110 functions as the gate insulator for a trench gate structure formed in the trench 104, as described in greater detail below. In an exemplary embodiment, the layer of dielectric material 110 is formed by thermally growing an oxide material, such as silicon dioxide, on the exposed bottom and sidewall surfaces 105, 107 of the trench 104 by exposing the device structure 100 to an oxidizing ambient at temperature in the range of about 800° C to about 1000° C to promote selective growth of oxide material on the exposed surfaces 105, 107 of silicon material 102 in the trench 104. For convenience, but without limitation, the dielectric material 110 is alternatively referred to herein as an oxide material. In an exemplary embodiment, the oxide material 110 is grown to a thickness of about 70nm. In practice, during the oxidation process, oxide material may also grow on the exposed dielectric material 106 and/or pad nitride 108, however, the oxidation rate of the silicon material 102 is sufficiently greater than the oxidation rate of the dielectric material 106 and/or pad nitride 108 such that the amount of oxide material formed on the dielectric material 106 and/or pad nitride 108 is negligible as compared to the oxide material 110 grown in the trench 104. It should be noted that in some alternative embodiments, the dielectric material 110 may be realized as a high-k dielectric material, and/or the dielectric material 110 may be formed in the trench 104 using a deposition process in lieu of the thermal oxidation process described above.

Referring now to FIG. 3, in an exemplary embodiment, the fabrication process continues by forming a layer of a conductive material 112 in the trench 104 to create a trench gate structure 114 for the device structure 100. In this regard, the conductive material 112 functions as the conductive gate electrode material of the trench gate structure 114. In an exemplary embodiment, the conductive material 112 is realized as polycrystalline silicon material that is conformably deposited overlying the device structure 100 of FIG. 2 by chemical vapor deposition (CVD) process at a temperature in the range of about 700° C to about 1000° C to a thickness greater than or equal to the depth of the trench 104 relative to the surface of the silicon material 102. For convenience, but without limitation, the conductive material 112 in the trench 104 may alternatively be referred to as the first polysilicon material. In an exemplary embodiment, the first polysilicon material 112 is in-situ doped by adding impurity-doping elements having the same conductivity-type as the doped silicon material 102 to the reactants used to form the first polysilicon material 112. For the exemplary N-channel device described herein, N-type impurity-doping elements, such as arsenic ions having a dopant concentration of about 6.5×10²⁰/cm³, are added to the reactants used to form the first polysilicon material 112.

After conformably depositing the first polysilicon material 112 overlying the device structure 100 of FIG. 2, the fabrication process continues by removing any excess polysilicon material 112 that is not formed in the trench 104. In this regard, in accordance with one embodiment, the excess polysilicon material 112 is removed using etch back planarization by performing RIE using an anisotropic etchant to remove the polysilicon material 112 until the upper surface of the pad nitride 108 is exposed. In some embodiments, the anisotropic etching may continue by removing some or all of the pad nitride 108 to reduce the height of the polysilicon material 112 in the trench 104 to a height more closely aligned with the surface of the silicon material 102. After performing the etch back of the excess polysilicon material 112, any remaining pad nitride 108 may be removed by performing a hot phosphoric acid etching process or another known etching process to obtain the device structure 100 of FIG. 3. The remaining polysilicon material 112 in the trench 104 functions as an N+ trench gate structure 114 for the exemplary N-type device structure 100 described herein. It should be noted that in alternative embodiments, in lieu of the etch back process described above, chemical-mechanical planarization (CMP) may be used to polish the polysilicon material 112 with a chemical slurry for a predetermined amount of time such that the CMP stops when the upper surface of the pad nitride 108 and/or silicon material 102 is exposed.

Referring now to FIGS. 4-6, in an exemplary embodiment, after forming the polysilicon material 112 in the trench 104, the fabrication process continues by forming a layer of a second conductive material 116 overlying the device structure 100 of FIG. 3 and selectively removing portions of the second conductive material 116 to define a lateral gate structure 118 overlying the silicon material 102. In this regard, the second conductive material 116 functions as the conductive gate electrode material of the lateral gate structure 118 and the underlying portion of dielectric material 106 remaining after removing portions of the second conductive material 116 functions as the gate insulator for the lateral gate structure 118. In an exemplary embodiment, the conductive material 116 is realized as an undoped polycrystalline silicon material that is conformably deposited overlying the device structure 100 of FIG. 3 by performing CVD at a temperature in the range of about 700° C to about 1000° C to a thickness in the range of about 500 nm to about 800 nm, resulting in the device structure 100 of FIG. 4. In this manner, in some embodiments, the second conductive material 116 fills any unoccupied space that may exist within the trench 104 below the surface of the silicon material 102 after the etch back of the first polysilicon material 112. For convenience, but without limitation, the conductive material 116 may alternatively be referred to as the second polysilicon material to distinguish from the first polysilicon material 112 used for the trench gate structure 114.

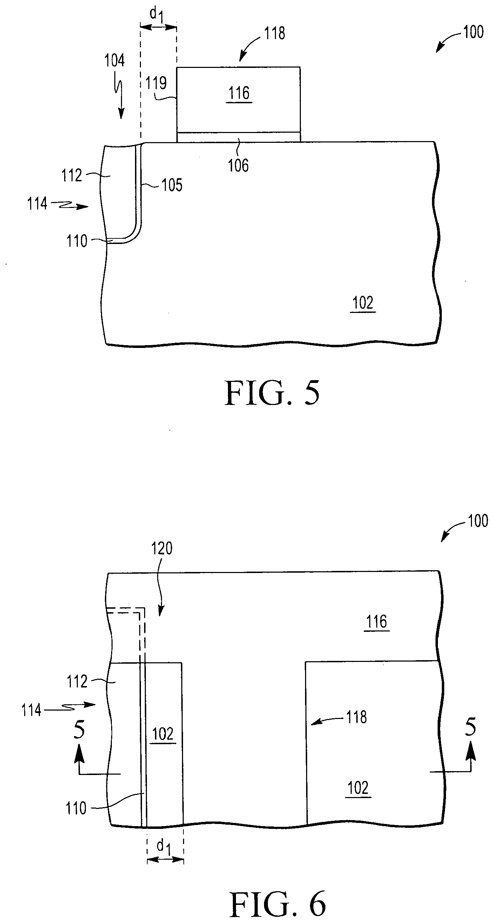

Referring now to FIG. 5, after conformably depositing the second polysilicon material 116, the fabrication process continues by selectively removing portions of the second polysilicon material 116 overlying the trench 104 and the silicon material 102 to define a lateral gate structure 118 overlying the silicon material 102 that is offset from the trench gate structure 114. For example, a layer of masking material (e.g., a photoresist material or the like) may be formed overlying the second polysilicon material 116, and portions of the masking material may be selectively removed (e.g., using photolithography or a suitable etchant chemistry) to define an etch mask that exposes a portion of the second polysilicon material 116 that overlies the trench gate structure 114 and a portion of the silicon material 102 adjacent to the trench 104 and/or trench gate structure 114. In an exemplary embodiment, the etch mask also exposes the portion of the second polysilicon material 116 that overlies the interior (or central) portion of the semiconductor material 102 opposite the trench 104 and/or trench gate structure 114. The exposed portions of the second polysilicon material 116 are selectively removed using the etch mask by performing RIE using an anisotropic etchant to remove the exposed portions of the second polysilicon material 116 while leaving the masked portions of the second polysilicon material 116 intact to create the lateral gate structure 118. In an exemplary embodiment, the second polysilicon material 116 is etched until exposing the surfaces of the unmasked portions of silicon material 102. In this regard, the etchant chemistry or etch conditions used to etch the second polysilicon material 116 may etch any exposed portions of the dielectric material 106. As illustrated in FIG. 5, the vertical sidewall 119 of the lateral gate structure 118 proximate the trench gate structure 114 is offset from the sidewall of the trench gate structure 114 (e.g., the vertical sidewall 105 of the trench 104 that defines the boundary or interface between the silicon material 102 and the oxide material 110 of the trench gate structure 114) by a distance (*d₁*) to expose a portion of the silicon material 102 adjacent to the trench gate structure 114 between the lateral gate structure 118 and the trench gate structure 114. As described in greater detail below, the portion of silicon material 102 between the trench gate structure 114 and the lateral gate structure 118 is subsequently doped to provide a channel corner region for the device structure 100. In practice, the offset distance (*d₁*) between the lateral gate structure 118 and the trench gate structure 114 may be chosen to optimize one or more performance parameters for the device structure 100 (e.g., on-resistance, energy/power handling capability, and the like).

FIG. 6 depicts a top view of the device structure 100 of FIG. 5 after etching the second polysilicon material 116. As illustrated in FIGS. 5-6, the width of the lateral gate structure 118 is substantially parallel to the width of the trench gate structure 114, and the gate structures 114, 118 are spaced apart by the offset distance (*d₁*) to expose the portion of silicon material 102 that is subsequently doped to provide the channel corner region for the device structure 100. As illustrated in FIG. 6, in an exemplary embodiment, the etch mask used to form the lateral gate structure 118 is patterned to mask a portion 120 of the second polysilicon material 116 deposited overlying a portion of the trench gate structure 114 that extends beyond the width of the silicon material 102. Thus, the masked portion 120 of the second polysilicon material 116 remains intact after etching to create the lateral gate structure 118, and the masked portion 120 extends orthogonally to (or perpendicular to) the widths of the gate structures 114, 118 between the two gate structures 114, 118 to provide an electrical connection between the trench gate structure 114 and the lateral gate structure 118. In an exemplary embodiment, the portion 120 functions as a gate terminal (or gate feed) for the device structure 100 that is capable of being accessed or otherwise being connected to external devices or overlying metal interconnect layers in a conventional manner. As illustrated in FIG. 6, the portion 120 of second polysilicon material 116 is contiguous or otherwise in contact with both the lateral gate structure 118 and the first polysilicon material 112 of the extension of the trench gate structure 114. In this manner, the trench gate structure 114 and the lateral gate structure 118 are electrically connected and have substantially the same electrical potential and, in combination, function as a common gate electrode for the device structure 100, as described in greater detail below.

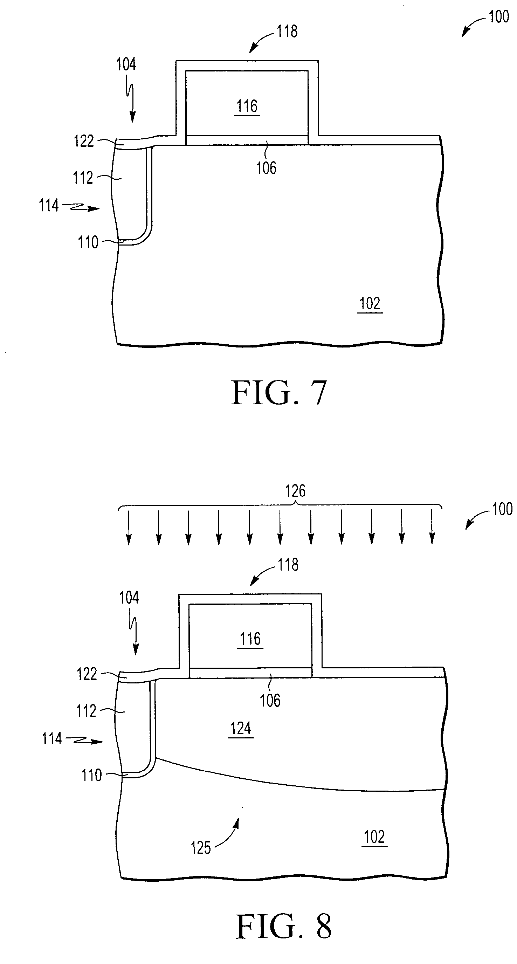

Referring now to FIG. 7, in an exemplary embodiment, after forming the lateral gate structure 118, the fabrication process continues by forming a layer of dielectric material 122, such as an oxide material, overlying the trench gate structure 114, the lateral gate structure 118, and the silicon material 102. In an exemplary embodiment, the layer of oxide material 122 is thermally grown on exposed surfaces of silicon material 102 and polysilicon materials 112, 116 by exposing the device structure 100 of FIG. 6 to an oxidizing ambient at temperature in the range of about 800° C to about 1000° C to promote selective growth of oxide material on the exposed silicon to a thickness in the range of about 10 nm to about 30 nm. The oxide material 122 has a substantially uniform thickness across the device structure 100 to allow subsequent ion implantation process steps to achieve more uniform dopant profiles. It should be noted that in alternative embodiments, the oxide material 122 may be deposited overlying the trench gate structure 114, the lateral gate structure 118, and the silicon material 102 by performing a deposition process in lieu of the thermal oxidation process described above.

Referring now to FIG. 8, in an exemplary embodiment, the fabrication process continues by forming a body region 124 in the region of silicon material 102 by implanting ions (illustrated by arrows 126) of a conductivity-determining impurity type that is opposite the conductivity type of the silicon material 102 and first polysilicon material 112. For example, for an exemplary N-channel device, the body region 124 is formed by implanting P-type ions, such as, boron ions (or a boron ionized species), with a dopant concentration in the range of about 1×10¹³/cm³ to about 2×10¹³/cm³ at an energy level of about 40 keV to about 100 keV to provide the body region 124 having a depth slightly less than the depth of the trench 104. After implanting ions 126, the fabrication process continues by performing a high-temperature annealing process to drive the implanted ions and activate the body region 124. In an exemplary embodiment, the device structure 100 may be heated to a temperature between about 600° C to about 1100° C for about eighty to one-hundred and sixty minutes using a furnace anneal to activate the body region 124. In an exemplary embodiment, the implanted ions diffuse vertically to provide a depth of the portion of the body region 124 adjacent to the trench gate structure 114 that is about 0.1 to 0.2 micrometers less than the depth of the trench 104 relative to the surface of the silicon material 102. Additionally, the implanted ions diffuse laterally such that the body region 124 extends laterally underneath the lateral gate structure 118 to provide a continuous P-type region underlying and adjacent to the lateral gate structure 118, as shown in FIG. 8. The body region 124 functions as the P- body portion of the body region of the N-type device structure 100 while the remaining portion 125 of the silicon material 102 that is not doped during the formation of the P- body region 124 (e.g., the portion of the silicon material 102 that ions 126 do not diffuse into) functions as the N+ drain region for the N-type device structure 100. In some embodiments, the gate structures 114, 118 may be masked prior to implanting the ions 126 for the body region 124. However, due to the relatively low dopant concentration for the ions 126 relative to the dopant concentration of the first polysilicon material 112 and subsequent ion implantation steps, the ions 126 may be implanted while the gate structures 114, 118 are unmasked without impacting performance of the device structure 100.

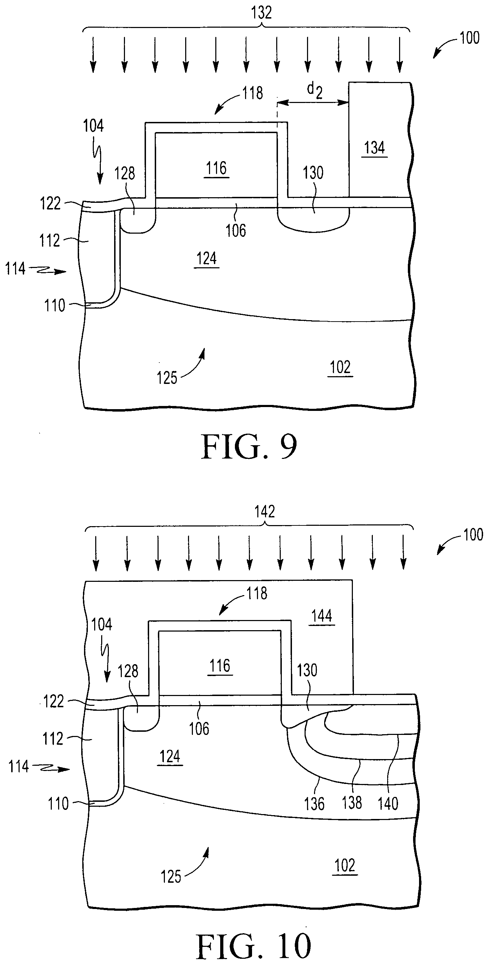

Referring now to FIG. 9, in an exemplary embodiment, after forming the body region 124, the fabrication process continues by forming doped regions 128, 130 within the body region 124 by implanting ions (illustrated by arrows 132) of a conductivity-determining impurity type that is opposite the conductivity type of the body region 124. As described in greater detail below, doped region 130 functions as a source region for the device structure 100, and doped region 128 functions as a channel corner region that prevents creation of uneven electric fields and reduces electric field crowding at the corner of the body region 124 between the lateral gate structure 118 and the trench gate structure 114 and facilitates creation of a curve in a continuous conductive channel flowing vertically along the trench gate structure 114 and laterally beneath the lateral gate structure 118. In an exemplary embodiment, the doped regions 128, 130 are formed by masking the device structure 100 of FIG. 8 with a masking material 134 (e.g., photoresist or the like) that is spaced apart from the lateral gate structure 118 in the direction opposite the trench gate structure 114 by a distance (*d₂*) to mask an interior (or central) portion of the body region 124 on the side of the lateral gate structure 118 that is opposite the trench gate structure 114 and expose portions of the body region 124 adjacent to the gate structures 114, 118. The doped regions 128, 130 are then formed by implanting ions 132 of the conductivity-determining impurity type that is opposite the conductivity-type of the body region 124 using the lateral gate structure 118 and the masking material 134 as an implantation mask. As illustrated, the depth of the implantation for the doped regions 128, 130 is less than the depth of the body region 124 relative to the surface of the silicon material 102, such that portions of the body region 124 are disposed between the doped regions 128, 130 and the drain region 125. In accordance with one embodiment, for an N-channel device, N+ doped regions 128, 130 are formed by performing a co-implantation step by implanting phosphorous ions (or a phosphorous ionized species) with a dopant concentration of about 1.5×10¹⁵/cm³ and energy level in the range of about 40 keV to about 100 keV and implanting arsenic ions (or an arsenic ionized species) with a dopant concentration of about 6×10¹⁵cm³ and energy level in the range of about 60 keV to about 120 keV. In an exemplary embodiment, the gate structures 114, 118 are not masked and doped by implanting ions 132 into the exposed polysilicon material 112, 116 during the formation of doped regions 128, 130. After implanting ions 132, the fabrication process continues by removing the masking material 134 and performing a high-temperature annealing process to drive the implanted ions and activate the doped regions 128, 130. In an exemplary embodiment, the device structure 100 is heated to a temperature of about 1000° C for about thirty minutes using a furnace anneal to activate the doped regions 128, 130. It should be appreciated that although the subject matter is described herein in the context of the doped regions 128, 130 being formed concurrently as part of the same ion implantation steps and having the same dopant concentration and/or dopant profile, in practice, the doped regions 128, 130 may be formed at part of separate ion implantation steps. For example, the portion of the body region 124 between gate structures 114, 118 may be masked while performing a first ion implantation step to form the source region 130, and the source region 130 may be masked while performing a second ion implantation step to form the channel corner region 128.

Referring now to FIG. 10, after forming the doped regions 128, 130, the fabrication process continues by forming enhancement regions 136, 138, 140 within the body region 124 by implanting ions (illustrated by arrows 142) of the same conductivity-determining impurity type as the body region 124. In this regard, the regions 124, 136, 138, 140 collectively provide the body region of the device structure 100. In an exemplary embodiment, the body enhancement regions 136, 138, 140 are formed by masking the device structure 100 with a masking material 144 that masks the gate structures 114, 118 and doped regions 128, 130 and leaves exposed the interior (or central) portion of the silicon material 102 and/or body region 124 adjacent to the source region 130 on the side of the lateral gate structure 118 opposite the trench gate structure 114. In this regard, in accordance with one or more embodiments, the masking material 144 extends beyond the lateral gate structure 118 in the direction opposite the trench gate structure 114 by a distance that is substantially equal to the offset distance (*d₂*) for the mask 134 used to form the source region 130. The body enhancement regions 136, 138, 140 are then formed by performing a chain implant to provide the desired dopant profile. In this regard, in an exemplary embodiment, a deep ion implantation is performed to create the deep body enhancement region 136, followed by an intermediate ion implantation to create the intermediate body enhancement region 138, followed by a shallow ion implantation to create the shallow body enhancement region 140. After implanting ions 142, the fabrication process continues by removing the masking material 144 and performing a high-temperature annealing process to drive the implanted ions and activate the body enhancement regions 136, 138, 140. In an exemplary embodiment, a rapid thermal annealing is performed to heat the device structure 100 to a temperature in the range of about 500° C to about 1000° C.

For the exemplary N-channel device described herein, the body enhancement regions 136, 138, 140 are formed by implanting P-type ions such that the body enhancement regions 136, 138, 140 function as P+ body regions for the N-channel device. In an exemplary embodiment, the deep body enhancement region 136 is formed by implanting P-type ions (e.g., boron ions) with a dopant concentration of about 1×10¹³/cm³ and energy level in the range of about 160 keV to about 260 keV. After forming the deep body enhancement region 136, the intermediate body enhancement region 138 is formed by implanting P-type ions with a dopant concentration of about 2×10¹⁵/cm³ and energy level of about 80 keV. After forming the intermediate body enhancement region 138, the shallow body enhancement region 140 is formed by implanting P-type ions with a dopant concentration of about 1.2×10¹⁵/cm³ and energy level in the range of about 20 keV to about 50 keV. By virtue of the different energy levels for the ion implantations steps, after the implanted ions diffuse during the anneal, the depth of the deep body enhancement region 136 is less than the depth of the P- body region 124 relative to the surface of the silicon material 102, the depth of the intermediate body enhancement 138 is less than the depth of the deep body enhancement region 136, and the depth of the shallow body enhancement region 140 is less than the depth of the intermediate body enhancement 138, as illustrated in FIG. 10. By virtue of the chain implantation steps, the shallow body enhancement region 140 has the highest dopant concentration, the intermediate body enhancement region 138 has a lower dopant concentration than the shallow body enhancement region 140, the deep body enhancement region 136 has a lower dopant concentration than the intermediate body enhancement region 136, and the P- body region 124 has a lower dopant concentration than the deep body enhancement region 136. In addition to enhancing the dopant concentration of the body of the device structure 100, the body enhancement regions 136, 138, 140 avoid creation of parasitic bipolar transistors and improve the energy handling capability of the device structure 100.

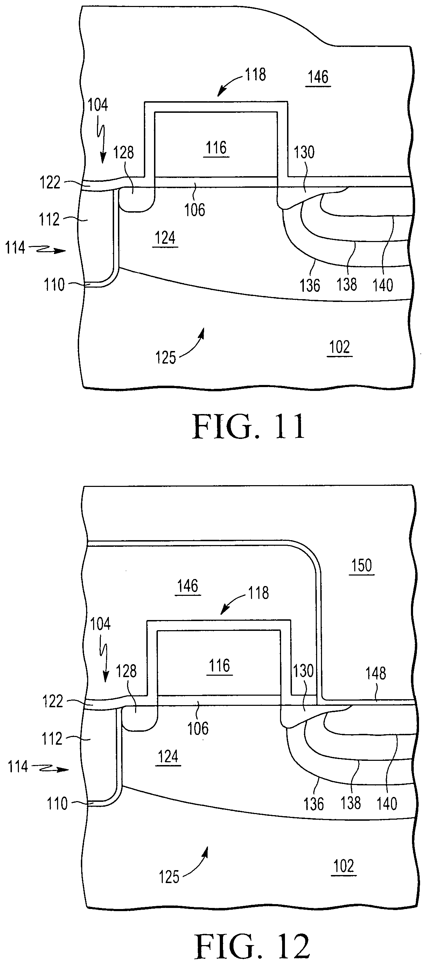

Referring now to FIG. 11, after forming the body enhancement regions 136, 138, 140, the fabrication process continues by forming a layer of a dielectric material 146 overlying the gate structures 114, 118, the doped regions 128, 130, and the body region 124, 136, 138, 140. In an exemplary embodiment, the layer of dielectric material 146 is formed by conformably depositing an oxide material, such as silicon dioxide, at a temperature in the range of about 700° C to about 1000° C to a thickness of about 500 nm overlying the gate structures 114, 118, the doped regions 128, 130, and the body region 124, 136, 138, 140 to obtain the device structure 100 illustrated in FIG. 11. The dielectric material 146 functions as an intralayer dielectric layer that electrically isolates the gate structures 114, 118 from a subsequently formed conductive layer, as described in the context of FIG. 12.

Referring now to FIG. 12, in an exemplary embodiment, after forming the layer of dielectric material 146, the fabrication process continues by selectively removing portions of the dielectric material 146 overlying at least a portion of the source region 130 and the portion of the body region 124, 136, 138, 140 adjacent to the source region 130. In this regard, a masking material may be applied to mask the portions of the dielectric material 146 overlying the gate structures 114, 118 and channel corner region 128 and patterned to expose the portion of the dielectric material 146 that overlies at least a portion of the source region 130 and the portion of the body region 124, 136, 138, 140 adjacent to the source region 130. The exposed portion of the dielectric material 146 is then removed by performing RIE using an anisotropic etchant chemistry that is selective to the masking material. In this manner, portions of the dielectric material 146 overlying the gate structures 114, 118 and channel corner region 128 remain intact while portions of the dielectric material 146 overlying at least a portion of the source region130 and the portion of the body region 124, 136, 138, 140 adjacent to the source region 130 are removed, as illustrated by FIG. 12.

In an exemplary embodiment, after selectively removing portions of the dielectric material 146, the fabrication process continues by forming one or more layers of conductive material 148, 150 overlying the exposed portions of the source region 130 and body region 124, 136, 138, 140, resulting in the device structure 100 of FIG. 12. In an exemplary embodiment, a first layer of a conductive material 148 is formed by conformably depositing a conductive metal material, such as titanium nitride, at a temperature in the range of about 400° C to about 1000° C to a thickness between about 10 nm to about 100 nm overlying the remaining dielectric material 146 and the exposed portions of the source region 130 and body region 124, 136, 138, 140. The conductive material 148 contacts the source region 130 and the body region 124, 136, 138, 140 to provide an electrical connection between the source region 130 and the body region 124, 136, 138, 140 of the device structure 100. In this manner, the source region 130 and the body region 124, 136, 138, 140 have the same electrical potential.

In an exemplary embodiment, after forming the first layer of conductive material 148, a second layer of conductive material 150 is formed by conformably depositing another conductive metal material, such as a copper material, at a temperature in the range of about 400° C to about 1000° C to a thickness of about 0.4 microns overlying the conductive metal material 148. In this manner, the conductive metal material 150 is electrically connected to the source region 130 and the body region 124, 136, 138, 140 via the underlying conductive metal material 148 while being insulated or otherwise isolated from the gate structures 114, 118 by the dielectric material 146. In an exemplary embodiment, the conductive metal material 150 functions as a source terminal for the device structure 100 that is capable of being accessed or otherwise being connected to external devices or overlying metal interconnect layers in a conventional manner. In this regard, the conductive metal material 150 provides a metal contact for the device structure 100 while conductive material 148 provides a thin buffer layer for an improved contact between the conductive metal material 150 and the source region 130 and the body region 124, 136, 138, 140.

Still referring to FIG. 12, the completed semiconductor device structure 100 includes a trench transistor structure (or trench MOSFET) and a lateral transistor structure. The trench transistor structure is comprised of the trench gate structure 114 (e.g., oxide material 110 and first polysilicon material 112), the channel corner region 128 adjacent to the trench gate structure 114 and/or trench 104, a portion of the drain region 125 adjacent to the trench gate structure 114 and/or trench 104, and the portion of the body region 124, 136, 138, 140 that is adjacent to the trench gate structure 114 and/or trench 104 and disposed between the channel corner region 128 and the portion of the drain region 125 adjacent to the trench gate structure 114 and/or trench 104. The lateral transistor structure is comprised of the lateral gate structure 118 (e.g., dielectric material 106 and second polysilicon material 116), the channel corner region 128, the source region 130, and the portion of the body region 124, 136, 138, 140 adjacent to and underlying the lateral gate structure 118 that is disposed between the channel corner region 128 and the source region 130.

By virtue of the electrical connection between the trench gate structure 114 and the lateral gate structure 118, when a voltage above a threshold voltage for the device structure 100 is applied to the gate structures 114, 118 (e.g., to portion 120), a conductive channel is created that runs vertically along the trench gate structure 114 (e.g., along trench sidewall surface 105) within the portion of the P-type body region 124, 136, 138, 140 between the N+ drain region 125 and the N+ channel corner region 128 and horizontally (or laterally) along the lateral gate structure 118 within the portion of the P-type body region 124, 136, 138, 140 between the N+ channel corner region 128 and the N+ source region 130. As set forth above, the N+ channel corner region 128 provides a curved portion of the conductive channel between the vertical portion of the conductive channel along the trench gate structure 114 (e.g., between drain region 125 and channel corner region 128) and the lateral portion of the conductive channel beneath the lateral gate structure 118 (e.g., between channel corner region 128 and source region 130). The vertical and lateral portions of the conductive channel allow the current flowing through the device structure 100 to be distributed among a greater area, thereby allowing the device structure 100 to achieve a more uniform thermal distribution, which, in turn, allows for the die size (or area) of the device structure 100 to be reduced relative to the conventional trench MOSFET to achieve the same current and/or energy handling capability. In other words, to achieve a desired current handling and/or energy handling requirement, the semiconductor device structure 100 of FIG. 12 requires less area than the conventional trench MOSFET. The properties of the dielectric material 110 and/or conductive material 112 for the trench gate structure 114 (e.g., thicknesses, dielectric constants, and the like) may be chosen to optimize performance of the trench transistor portion of the device structure 100 independently of the properties of the dielectric material 106 and/or conductive material 116 for the lateral gate structure 118 (e.g., thicknesses, dielectric constants, and the like), which in turn, may be independently chosen to optimize performance of the lateral transistor portion of the device structure 100.

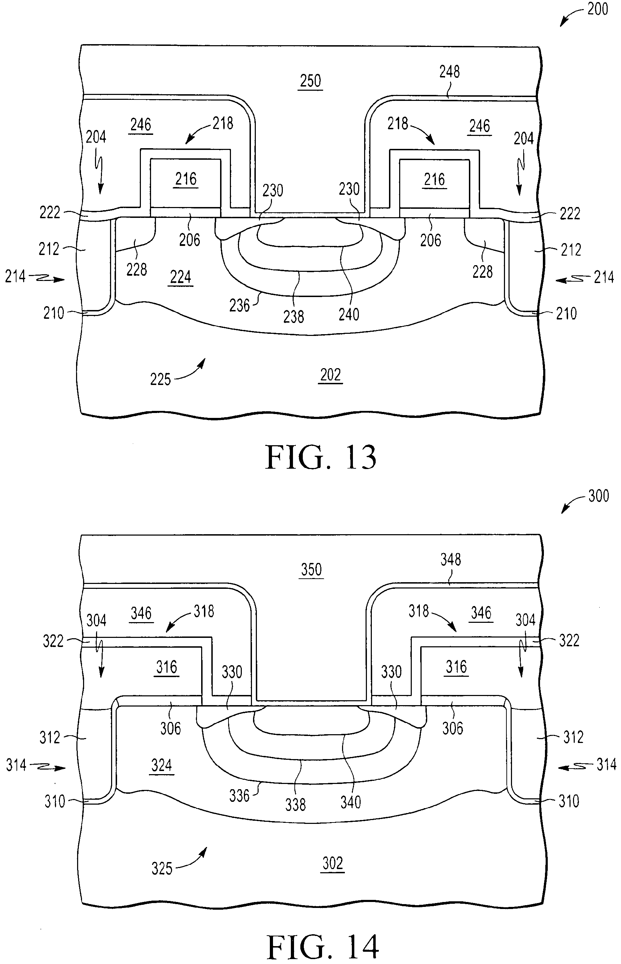

Referring now to FIG. 13, the fabrication process described above in the context of FIGS. 1-12 may be performed to fabricate a semiconductor device structure 200 having a pair of trench gate structures 214 and a pair of lateral gate structures 218. In this regard, trench gate structures 214 comprised of a conductive material 212 and a dielectric material 210 may be formed in trenches 204 formed on opposing sides of a region of semiconductor material 202 having a first conductivity type. After forming the trench gate structures 214, lateral gate structures 218 comprised of a conductive material 216 and a dielectric material 206 are formed overlying the semiconductor material 202, wherein each lateral gate structure 218 is disposed proximate a respective trench gate structure 214 and offset by a distance to expose portions of the semiconductor material 202 between a respective lateral gate structure 218 and a respective trench gate structure 214. In the illustrated embodiment, after forming the lateral gate structures 218, a layer of dielectric material 222 is formed overlying the gate structures 214, 218 and the semiconductor material 202, and a deep body region 224 is formed by implanting ions having a second conductivity type into the region of semiconductor material 202. After forming the deep body region 224, a masking material is formed overlying the interior (or central) portion of the body region 224 between the lateral gate structures 218 and offset from the lateral gate structures 218 by a distance to expose portions of the body region 224 adjacent to the lateral gate structures 218, and ions of the first conductivity type are implanted into the exposed portions of the body region 224 using the masking material and the lateral gate structures 218 as implantation masks to form channel corner regions 228 and source regions 230 within the body region 224. As described above, the channel corner regions 228 are adjacent to the trench gate structures 214 and disposed between a lateral gate structure 218 and a respective trench gate structure 214, and the source regions 230 are disposed on the inside of the lateral gate structures 218 and separated by the interior (or central) portion of the body region 224. After forming the channel corner regions 228 and the source regions 230, another masking material is formed overlying the channel corner regions 228, the source regions 230, and the gate structures 214, 218, and ions having the same conductivity type as the body region 224 are implanted into the exposed interior (or central) portion of the body region 224 between source regions 230 to form body enhancement regions 236, 238, 240. After forming body enhancement regions 236, 238, 240, a dielectric material 246 is formed overlying the gate structures 214, 218 and channel corner regions 228 that leaves exposed portions of the source regions 230 and the body region 224, 236, 238, 240 between the lateral gate structures 218. Conductive materials 248, 250 are then formed overlying the exposed portions of the source regions 230 and the body region 224, 236, 238, 240. The conductive materials 248, 250 are electrically connected to the source regions 230 and the body region 224, 236, 238, 240 while being insulated or otherwise isolated from the gate structures 214, 218 by the dielectric material 246, and the uppermost conductive material 250 functions as a source terminal for the device structure 200 that is capable of being accessed or otherwise being connected to external devices or overlying metal interconnect layers in a conventional manner, as described above.

By virtue of the electrical connection between the conductive material 212 of the trench gate structures 214 and the conductive material 216 of the lateral gate structures 218, when a voltage above a threshold voltage for the device structure 200 is applied to the gate structures 214, 218, conductive channels are created that run vertically along the trench gate structures 214 within the portions of the body region 224, 236, 238, 240 between the drain region 225 and the channel corner regions 228 and horizontally (or laterally) along the lateral gate structure 218 within portions of the body region 224, 236, 238, 240 between the channel corner regions 228 and the source regions 230. In this manner, the current flowing through the device structure 200 is distributed vertically and laterally, thereby distributing heat vertically and horizontally through the device structure 200. By distributing the current (or energy) consumed by the device structure 200 across a greater area, the device structure 200 achieves a more uniform thermal distribution and allows for the die size (or area) of the device structure 200 to be reduced relative to the conventional trench MOSFET to achieve the same current and/or energy handling capability.

Referring now to FIG. 14, the fabrication process described above in the context of FIGS. 1-12 may be performed to fabricate a semiconductor device structure 300 having lateral gate structures 318 that are integral with trench gate structures 314. As described above in the context of FIGS. 1-4, trench gate structures 314 comprised of a conductive material 312 and a dielectric material 310 are formed in trenches 304 on opposing sides of a region of semiconductor material 302, and a conductive material 316 is formed overlying the device structure 300 after forming the trench gate structures 314. As described above in the context of FIGS. 5-6, the interior (or central) portion of the conductive material 316 is removed to obtain lateral gate structures 318. In this regard, for the embodiment of FIG. 14, portions of the conductive material 316 overlying the trench gate structures 314 and portions of the conductive material 316 overlying the semiconductor material 302 proximate the trench gate structures 314 are masked prior to removing the interior portion of the conductive material 316. Thus, the portions of the conductive material 316 overlying the trench gate structures 314 and the portions of the conductive material 316 overlying the semiconductor material proximate the trench gate structures 314 are not removed and remain intact, such that the conductive material 316 of the lateral gate structures 318 remains in contact with the conductive material 312 of the trench gate structures 314. Portions of the dielectric material 306 between the semiconductor material 302 and the remaining conductive material 316 remain intact and function as the gate dielectric for the lateral gate structures 318.

As described above, after forming the lateral gate structures 318, a layer of dielectric material 322 is formed overlying the device structure 300, and a deep body region 324 is formed by implanting ions having a conductivity type opposite the conductivity type of semiconductor material 302 into the exposed interior portion of the semiconductor material 302. In the illustrated embodiment of FIG. 14, not being part of the invention, the deep body region 324 is formed by
performing tilted implants to implant ions underneath the lateral gate structures 318 to provide a deep body region 324 that is adjacent to the trench gate structures 314 and underlies the lateral gate structures 318. After forming the deep body region 324, the interior (or central) portion of the body region 324 is masked and ions of the same conductivity type as the drain region 325 of semiconductor material 302 are implanted into the exposed portions of the body region 324 to form source regions 330. After forming the source regions 330, the source regions 330 and the gate structures 314, 318 are masked, and ions having the same conductivity type as the body region 324 are implanted into the exposed portion of the body region 324 between source regions 330 to form body enhancement regions 336, 338, 340. After forming body enhancement regions 336, 338, 340, a dielectric material 346 is formed overlying the gate structures 314, 318 that leaves exposed portions of the source regions 330 and the body region 324, 336, 338, 340 between the lateral gate structures 318, and conductive materials 348, 350 are formed overlying the exposed portions of the source regions 330 and body region 324, 336, 338, 340. By virtue of the electrical connection between the conductive materials 312, 316 of the gate structures 314, 318, when a voltage above a threshold voltage for the device structure 300 is applied to the gate structures 314, 318, conductive channels are created that run vertically along the trench gate structures 314 and horizontally beneath the lateral gate structures 318 within the portions of the body region 324, 336, 338, 340 between the drain region 325 and the source regions 330. In this manner, the current flowing through the device structure 300 is distributed among a greater area, thereby achieving a more uniform thermal distribution and allowing for the die size (or area) of the device structure 300 to be reduced relative to the conventional trench MOSFET to achieve the same current and/or energy handling capability.

In conclusion, the invention relates to:
a method for fabricating a semiconductor device structure. The method involves the steps of forming a first gate structure adjacent to a first region of semiconductor material having a first conductivity type, forming a second gate structure being a lateral gate structure overlying the first region.
   forming a second region of semiconductor material having a second conductivity type within the first region of semiconductor material, and forming a third region of semiconductor material having the first conductivity type within the second region, wherein a first portion of the second region underlying the second gate structure is disposed between the first gate structure and the third region. In this embodiment of the invention, forming the second gate structure comprises forming the second gate structure offset from the first gate structure. In this embodiment, the method further comprises the step of forming a fourth region of semiconductor material having the first conductivity type within the second region, the first portion of the second region being disposed between the fourth region and the third region. In accordance with this embodiment, forming the fourth region comprises forming the fourth region adjacent to the first gate structure, wherein a second portion of the second region is disposed between the fourth region and the first region. In this embodiment, forming the fourth region comprises implanting ions having the first conductivity type into the second region using the second gate structure as an implantation mask. In accordance with this embodiment, forming the second gate structure comprises forming a layer of conductive material overlying the first region and removing a first portion of the layer of conductive material to expose a first portion of the first region, the first portion being adjacent to the first gate structure, and forming the second region comprises implanting ions having the second conductivity type into the first portion of the first region to form a second portion of the second region adjacent to the first gate structure, the second portion of the second region being disposed between the first portion of the second region and the first gate structure. In this embodiment, the method involves the step of forming a fourth region of semiconductor material having the first conductivity type within the second portion of the second region, wherein forming the fourth region comprises implanting ions having the first conductivity type into the second portion of the second region using the conductive material as an implantation mask. In a further embodiment, not being part of the present invention, the method further comprises the step of masking a third portion of the second region on a side of the second gate structure opposite the first gate structure prior to implanting ions having the first conductivity type, wherein implanting ions having the first conductivity type to form the fourth region concurrently forms the third region, the third region being disposed between the first portion of the second region and the third portion of the second region.

While at least one exemplary embodiment has been presented in the foregoing detailed description, it should be appreciated that a vast number of variations exist. It should be understood that various changes can be made in the function and arrangement of elements without departing from the scope defined by the claims.

## Claims

1. A method for fabricating a semiconductor device structure, the method comprising:
forming a first gate structure (114) being a trench gate structure adjacent to a first region of semiconductor material (102) having a first conductivity type, and
forming a second gate structure (118) being a lateral gate structure overlying the first region and offset from the first gate structure (114); and subsequently:
forming a second region (124) being a body region of semiconductor material (102) having a second conductivity type within the first region of semiconductor material (102) by implanting ions (126) having the second conductivity type into the first region and diffusing the implanted ions;
forming, by implanting ions, a further region (128) of semiconductor material (102) having the first conductivity type within the body region (124) adjacent to the trench gate structure (114); and
forming, by implanting ions a third region (130) being a source region of semiconductor material (102) having the first conductivity type within the second region (124), wherein a first portion of the second region (124) underlying the second gate structure (118) is disposed between the first gate structure (114) and the third region (130).

2. The method of claim 1, further comprising
forming a layer of dielectric material (106) overlying the semiconductors material;
and wherein:
forming the second gate structure (118) comprises:
forming a layer of conductive material (116) overlying the dielectric material overlying the first region, and
removing a first portion of the layer of conductive material and of the dielectric material to expose a first portion of the first region, the first portion being adjacent to the first gate structure (114).

## Patentansprüche

1. Verfahren zum Fabrizieren einer Halbleiterbauelementstruktur, wobei das Verfahren umfasst:
Bilden einer ersten Gatestruktur (114) als eine Grabengatestruktur bei einem ersten Gebiet aus Halbleitermaterial (102) mit einem ersten Leitfähigkeitstyp, und
Bilden einer zweiten Gatestruktur (118) als eine laterale Gatestruktur über dem ersten Gebiet liegend und von der ersten Gatestruktur (114) versetzt; und danach
Bilden eines zweiten Gebiets (124) mit einem Körpergebiet aus Halbleitermaterial (102) mit einem zweiten Leitfähigkeitstyp innerhalb des ersten Gebiets aus Halbleitermaterial (102) durch Implantieren von Ionen (126) mit dem zweiten Leitfähigkeitstyp in das erste Gebiet und Diffundieren der implantierten Ionen;
Bilden, durch Implantieren von Ionen, eines weiteren Gebiets (128) aus Halbleitermaterial (102) mit dem ersten Leitfähigkeitstyp innerhalb des Körpergebiets (124) bei der Grabengatestruktur (114); und
Bilden, durch Implantieren von Ionen, eines dritten Gebiets (130) mit einem Sourcegebiet aus Halbleitermaterial (102) mit dem ersten Leitfähigkeitstyp innerhalb des zweiten Gebiets (124), wobei ein erster Abschnitt des zweiten Gebiets (124) unter der zweiten Gatestruktur (118) liegend zwischen der ersten Gatestruktur (114) und dem dritten Gebiet (130) angeordnet ist.

2. Verfahren nach Anspruch 1, weiter umfassend:
Bilden einer Schicht aus dielektrischem Material (106) über dem Halbleitermaterial liegend;
und wobei
das Bilden der zweiten Gatestruktur (118) umfasst:
Bilden einer Schicht aus leitfähigem Material (116) über dem über dem ersten Gebiet liegenden dielektrischen Material liegend; und
Entfernen eines ersten Abschnitts der Schicht aus leitfähigem Material und des dielektrischen Materials, um einen ersten Abschnitt des ersten Gebiets zu exponieren, wobei sich der erste Abschnitt bei der ersten Gatestruktur (114) befindet.

## Revendications

1. Procédé de fabrication d'une structure de dispositif semi-conducteur, le procédé comprenant :
la formation d'une première structure de grille (114) qui est une structure de grille en tranchée adjacente à une première région de matériau semi-conducteur (102) ayant un premier type de conductivité, et
la formation d'une deuxième structure de grille (118) qui est une structure de grille latérale recouvrant la première région et décalée par rapport à la première structure de grille (114) ; et, subséquemment :
la formation d'une deuxième région (124) qui est une région de corps de matériau semi-conducteur (102) ayant un deuxième type de conductivité à l'intérieur de la première région de matériau semi-conducteur (102) par implantation d'ions (126) ayant le deuxième type de conductivité dans la première région et par diffusion des ions implantés ;
la formation, par implantation d'ions, d'une région supplémentaire (128) de matériau semi-conducteur (102) ayant le premier type de conductivité à l'intérieur de la région de corps (124) en position adjacente à la structure de grille en tranchée (114) ; et
la formation, par implantation d'ions, d'une troisième région (130) qui est une région de source de matériau semi-conducteur (102) ayant le premier type de conductivité à l'intérieur de la deuxième région (124), une première portion de la deuxième région (124) sous-jacente à la deuxième structure de grille (118) étant disposée entre la première structure de grille (114) et la troisième région (130).

2. Procédé selon la revendication 1, comprenant en outre
la formation d'une couche de matériau diélectrique (106) recouvrant le matériau semi-conducteur ;
et dans lequel :
la formation de la deuxième structure de grille (118) comprend :
la formation d'une couche de matériau conducteur (116) recouvrant le matériau diélectrique recouvrant la première région, et
l'enlèvement d'une première portion de la couche de matériau conducteur et du matériau diélectrique pour exposer une première portion de la première région, la première portion étant adjacente à la première structure de grille (114).
